# EUROPÄISCHE PATENTANMELDUNG

(11) **EP 0 836 234 A2**
(43) Veröffentlichungstag der Anmeldung: **15.04.1998**
(21) Anmeldenummer: 97112584.4
(22) Anmeldetag: 23.07.1997
(51) Int. Cl.: H01L 33/00

(54) **Optoelektronisches Bauelement**

(30) Priorität: 12.10.1996 DE 19642168
(71) Anmelder: Preh-Werke GmbH & Co. KG, 97616 Bad Neustadt (DE)
(72) Erfinder: Bauer, Karl-Heinz, 97616 Bad Neustadt (DE); Brüggemann, Ulrich, 97618 Heustreu (DE)
(74) Vertreter: Pfeiffer, Helmut, Dipl.-Ing.

(57) **Zusammenfassung**

Die Erfindung betrifft ein Optoelektronisches Bauelement, das zur besseren Lichtverteilung in die horizontale Ebene in einem Kopfbereich (3) eines Körpers (2) mit Sockelteil (4) und Anschlüssen (5) eine zentrische Einsenkung (6) aufweist.

Eine emittierte Lumineszenzstrahlung (7) wird durch diese zentrische Einsenkung (6) in die horizontale Ebene abgelenkt. Dadurch wird die Bauhöhe des Bauelementes (1) reduziert und eine bessere Lichteinspeisung im Lichtleiter ermöglicht.

Durch eine konische zentrische Einsenkung ist eine Lichtverteilung rundum möglich durch eine pyramidenförmige Einsenkung (6) wird die Lumineszenzstrahlung (7) in vier Balken konzentriert, so daß sich die Lumineszenzstrahlung (7) besser in die vier an dieser Stelle kreuzenden Lichtleiter einspeisen läßt.

## Beschreibung

Die Erfindung betrifft ein optoelektronisches Bauelement nach dem Oberbegriff des Patentanspruchs 1.

Optoelekronische Bauelemente werden zur Beleuchtung von Schaltern und Anzeigekomponenten, beispielsweise für den Innenraum von Kraftfahrzeugen, insbesondere von Armaturenbrettern benötigt. Dafür verwendete handelsübliche LED (lichtemittierende Diode) besitzen eine am Kopf angeformte Linse, wie beispielsweise in der EP 0 580 082 B1 dargestellt.

Die in der LED erzeugten Lumineszenzstrahlung wird über herkömmliche Lichtleiter oder direkt zur Beleuchtung von Schaltern und Anzeigekomponenten genutzt. Der Nachteil hierbei besteht darin, daß ein Lichtverlust im Bereich der Linse eintritt, wenn die Lumineszenzstrahlung (Licht) direkt in die horizontal angeordneten Lichtleiter eingekoppelt wird.

Die US-PS 49 07 044 beschreibt ein optisches Senderbauelement, wobei die dargestellte LED eine linsenförmige Ausformung im Kopfbereich aufweist. Die Lichtabstrahlung tritt dabei oberhalb des Kopfbereiches aus. Dies ist gewollt, da die Lichtabstrahlungen gegen einen oberhalb des LED-Kopfes befindlichen Lichtaustritt gleichmäßig verteilt werden sollen. Durch die Gestaltung der seitenflächen in einer Abstrahleinrichtung bricht sich das an der Linse abgelenkte Licht in Richtung einer auszuleuchtenden Oberfläche.

Eine gleichmäßige Lichtverteilung einer beleuchteten Anzeigetafel beschreibt die DE 39 31 668 A1, wobei auch hier der Lichtaustritt aus der Beleuchtungs-vorrichtung oberhalb des LED-Kopfes erfolgt. Dieser LED-Kopf weist ebenfalls eine linsenförmige Ausformung auf. Durch seitliche Reflexionsschichten wird innerhalb einer Ausnehmung, in der sich die LED befindet, eine gleichmäßige Ausleuchtung von Zeichen einer Anzeigetafel realisiert.

Die JP 61-127 186 (A) zeigt eine Beleuchtungseinrichtung mit einer LED innerhalb eines Gehäuses beziehungsweise einer Ausnehmung, bei der sich ebenfalls oberhalb des Kopfbereiches der LED der gewollte Lichtaustritt aus der Beleuchtungseinrichtung befindet. Durch seitliche Reflexion zur Oberseite der Beleuchtungseinrichtung erfolgt die Lichtverteilung. Im Kopfbereich der LED befindet sich eine Einkerbung, wobei diese aus zweiseitig gerade zulaufenden Flächen gebildet wird. Hierbei erfolgt die erste Lichtumlenkung an diesen zwei Flächen, eine zweite durch die seitliche Reflexion. Die Einkerbung befindet sich zudem an einem eckigen LED-Körper und schließt nur an zwei Seiten des LED-Körpers im Kopfbereich ab.

Das DE 93 03 327 U1 beinhaltet eine Beleuchtungsvorrichtung mit zumindestens einer Reflexionsoberfläche. Diese befindet sich an einer Außenfläche des Gehäuses. Die Gestaltung der Beleuchtungseinrichtung wurde so gewählt, daß ein Einsatz anstelle von Lichtleiter erfolgt.

Das DE 85 00 013 U1 beschreibt ein optisches Bauelement mit variabler Abstrahl- bzw. Empfangscharakteristik. Dazu weisen unter anderem die Lichtaustrittsflächen linsenförmige, vorzugsweise reflektierende Kurven auf. Dadurch wird ein Lichtaustritt auch unterhalb der LED ermöglicht. Das Licht wird nicht nur horizontal abgelenkt.

Es ist Aufgabe der vorliegenden Erfindung, ein optoelektronisches Bauelement zu schaffen, mit dem es möglich ist, das Licht mit möglichst geringem Verlust horizontal in Lichtleiter einzukoppeln.

Diese Aufgabe wird mit den Merkmalen des Patentanspruchs 1 gelöst.

Durch die zur Mitte greifende Einsenkung im Kopfbereich der LED wird das abgestrahlte Licht in die horizontale Ebene umgelenkt. Die so konzentrierte Lichtmenge wird horizontal abgestrahlt und maximal von den die LED umgebenden Lichtleitern aufgenommen.

Vorteilhafte Ausführungen der Erfindung sind in den Unteransprüchen angegeben.

So kann durch die pyramidenförmige Ausnehmung bzw. Einsenkung das Licht horizontal in vier Balken umgelenkt werden. Eine mehreckige Einsenkung erhöht das Breitenspektrum für den Einsatz der vorgeschlagenen LED.

Die Erfindung wird anhand eines Ausführungsbeispiels mit Zeichnung näher erläutert.

Es zeigen :
Fig.1
   eine Seitenansicht einer LED vergrößert,
Fig.2a
   eine Draufsicht der LED mit konischer Einsenkung,
Fig.2b
   eine Draufsicht der LED mit pyramidenförmiger Einsenkung,
Fig. 2c
   eine Draufsicht einer eckigen LED mit pyramidenförmiger Einsenkung,

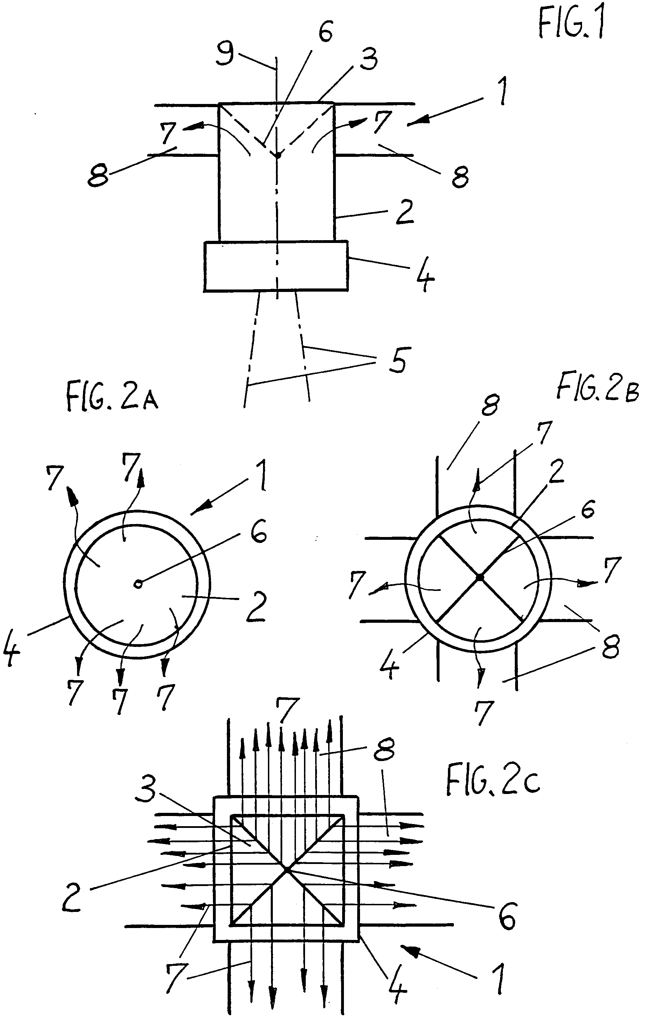

In Figur 1 dargestellt ist ein optoelektronisches Bauelement 1 mit Lumineszenzstrahlung emittierenden Eigenschaften. Dieses optoelektronische Bauelement 1 besteht aus einem Körper 2, der sich in einen Kopfbereich 3 und einen Sockelbereich 4 gliedert. Am Sockelbereich 4 befinden sich elektrische Anschlüsse 5. Der Körper 2 ist in der Regel teilweise zumindest im Kopfbereich 3 aber auch vollständig aus lichttransparentem Kunststoff aufgebaut. Die Anschlüsse 5 dienen auf bekannte Art und Weise der Spannungsversorgung des Bauelementes 1. Beim hier vorgeschlagenen Bauelement 1 befindet sich im Kopfbereich 3 in Richtung zur Längsachse 9 des Körpers 2 eine zentrische Einsenkung 6. Mit 8 ist ein lichttransparenter Austrittsbereich einer Lumineszenzstrahlung 7 im Kopfbereich 3 gekennzeichnet.

Der Körper 2 und der Sockelbereich 4 können rund oder recht- bzw. mehreckig ausgestaltet sein. Auch Kombinationen untereinander sind möglich, so daß ein rechteckiger Sockel 4 mit einem runden Körper 2 aufgebaut sein kann.

Wie in Fig. 2a dargestellt, weist das Bauelement 1 eine runde Form auf. Hierbei verläuft die Einsenkung 6 konisch.

Eine weitere Möglichkeit stellt Fig. 2b dar, wobei die zentrische Einsenkung 6 pyramidenförmig gestaltet ist.

In Fig. 2c ist das Bauelement 1 mit rechteckigem Körper 2 und rechteckigem Sockelbereich 4 dargestellt. Die zentrische Einsenkung 6 ist hierbei pyramidenförmig, kann aber auch konisch sein (nicht dargestellt).
Das optoelektronische Bauelement 1 wird in herkömmlicher Art und Weise hergestellt.
Dabei wird das Kopfteil 3 mit seiner zentrischen Einsenkung 6 durch ein bekanntes Spritzgußverfahren beim Umspritzen der LED an- bzw. eingeformt. Die Geometrie/Form des zu umspritzenden Werkzeuges, das selber hochglanzpoliert ist, bestimmt auch die innere Form der zentrischen Einsenkung 6. Die zentrische Einsenkung 6 weist, bedingt durch die hochglanzpolierte Oberfläche des Werkzeugs, eine sehr glatte und porenfreie Oberfläche auf, so daß die Lumineszenzstrahlung 7 an dieser Einsenkung 6 abgelenkt wird, d. h. sich bricht.

Durch Anlegen einer Betriebsspannung wird über die Anschlüsse 5 die Halbleiterdiode, aus der das optoelektronische Bauelement 1 im Grundaufbau besteht, auf bekannte Art und Weise dazu veranlaßt, im Bereich ihres pn-Überganges spontan Lumineszenzstrahlung 7 zu emittieren. Durch die zentrische Einsenkung 6 wird diese Lumineszenzstrahlung 7 zum Austrittsbereich 8 horizontal abgelenkt. Die Größe der horizontalen Ablenkung, d. h. die Intensität der abgelenkten Lumineszenzstrahlung 7 im Austrittsbereich 8, ergibt sich aus der Tiefe der zentrischen Einsenkung 6 zum Sockelbereich 4 hin. Sind die konisch/pyramidenförmig aufeinander zulaufenden Seiten kurz, so erfolgt eine Konzentrierung der in die Horizontale abgelenkten Lumineszenzstrahlen 7 in einem Teil des lichttransparenten Kopfbereiches 3. Der Austrittsbereich 8 ist höhenmäßig klein.

Die zentrische Einsenkung 6 besitzt eine kleine Tiefe. Eine große Tiefe der Einsenkung 6 ergibt eine breite Ablenkung der Lumineszenzstrahlung 7 und einen in der Höhe zum Körper 2 großen Austrittsbereich 8.

Bei einem runden Kopfbereich 3 des Körpers 2 und einer konischen zentrischen Einsenkung 6 erfolgt eine gleichmäßige Lumineszenzstrahlung 7 rundherum in horizontaler Ebene, bei einer pyramidenförmigen (vier Seiten) zentrischen Einsenkung 6 erfolgt die Umlenkung der Lumineszenzstrahlung 7 in vier Balken (Richtungen), wobei durch die Rundung der äußeren Kante des Körpers 2 im Austrittsbereich 8 eine zusätzliche Brechung der austretenden Lumineszenzstrahlung 7 an dieser Wölbung stattfindet, so daß es vorteilhaft ist, die pyramidenförmige Einsenkung 6 in einem eckigen Kopfbereich 3 mit eckigem Körper 2 anzuformen. Dabei ist zu beachten, daß der Anfang der zentrisch zueinander laufenden Seiten jeweils in den Ecken der Einsenkung 6 angebracht ist.

Durch einen bekannten, nicht näher dargestellten, in der horizontalen Ebene zum optoelektronischen Bauelement 1 angeordneten Lichtleiter, wird diese Lumineszenzstrahlung 7 an diverse, mit den Lichtleitern in Verbindung stehende Schalter und Anzeigekomponenten in herkömmlicher Art und Weise verteilt. Bei einem runden Kopfbereich 3 sind die Lichtleiter vorzugsweise rund um das Bauelement 1, in horizontaler Ebene mit dem Austrittsbereich 8 abgeschlossen, angeordnet. Bei einem eckigen, beispielsweise rechteckigen Kopfbereich 3, liegen die Lichtleiter an den abgestrahlten Balken direkt an.

Die Balkenanzahl der abgestrahlten Lumineszenzstrahlung 7 ergibt sich aus der geometrischen Einsenkung 6 im Kopfbereich 3. Bei einer sechseckigen Einsenkung 6 wären dies sechs Balken. Die Lumineszenzstrahlung 7 wird dann in sechs Balken abgestrahlt. Auch andere geometrische Formen der Einsenkung 6 sind je nach Notwendigkeit möglich, wobei die äußere Gestaltung des Kopfbereichs 3 der inneren Einsenkung 6 angepaßt sein sollte. Besitzt die Einsenkung 6 beispielsweise eine achteckige Form, so sollten dieser Form acht Austrittsbereiche 8 durch einen achteckigen Kopfbereich 3 zugeordnet werden, wobei die Einsenkung 6 in den jeweils oberen Eckpunkten der Austrittsbereiche 8 beginnt.

## Patentansprüche

1. Optoelektronisches Bauelement mit Lumineszenzstrahlung emittierenden Eigenschaften, bestehend aus einem mit elektrischen Anschlüssen versehenen Körper, der lichttransparent zum Austritt der im Körper erzeugten Lumineszenzstrahlung ausgebildet ist und eine Ausformung aufweisen, dadurch gekennzeichnet, daß das optoelektronische Bauelement (1) im Bereich des lichttransparenten Austritts (8) der Lumineszenzstrahlung (7) im Kopfbereich (3) als Ausformung eine zentrische Einsenkung (6) in Richtung der Längsachse (9) des Körpers (2) zur horizontalen Umlenkung der Lumineszenzstrahlung (7) aufweist, wobei die zentrische Einsenkung (6) mit dem Körper (2) im Kopfbereich (3) allseitig und kantig anschließt.

2. Optoelektronisches Bauelement nach Anspruch 1, dadurch gekennzeichnet, daß die zentrische Einsenkung (6) eine konische Einsenkung ist.

3. Optoelektronisches Bauelement nach Anspruch 1, dadurch gekennzeichnet, daß die zentrische Einsenkung (6) pyramidenförmig ausgebildet ist.

4. Optoelektronisches Bauelement nach Anspruch 1, dadurch gekennzeichnet, daß die zentrische Einsenkung (6) mehreckig ausgeführt ist.
